Europäisches Patentamt

European Patent Office

Office européen des brevets

(19)

(11) **EP 0 544 121 B1**

(12) ## EUROPEAN PATENT SPECIFICATION

(45) Date of publication and mention
of the grant of the patent:
**08.04.1998 Bulletin 1998/15**

(51) Int Cl.6: **G01R 31/36**

(21) Application number: **92118686.2**

(22) Date of filing: **30.10.1992**

(54) **A device for measuring the internal resistance of batteries, particularly of motor vehicles**

Gerät zur Messung des internen Widerstandes von Batterien, besonders in Motorfahrzeugen

Dispositif pour mesurer la résistance interne des batteries, en particulier de véhicule automobile

(84) Designated Contracting States:
**CH DE ES FR GB IT LI NL SE**

(30) Priority: **31.10.1991 IT TO910828**

(43) Date of publication of application:
**02.06.1993 Bulletin 1993/22**

(73) Proprietor: **IVECO FIAT S.p.A.**
**10156 Torino (IT)**

(72) Inventors:
  • **Cesarano, Alfonso**
    **I-10100 Torino (IT)**

  • **Cannella, Sergio**
    **I-10100 Torino (IT)**

(74) Representative: **Cerbaro, Elena et al**
    **STUDIO TORTA S.r.l.,**
    **Via Viotti, 9**
    **10121 Torino (IT)**

(56) References cited:
**WO-A-83/02005**          **WO-A-90/06522**
**US-A- 3 731 189**        **US-A- 3 984 762**

  • **PATENT ABSTRACTS OF JAPAN vol. 12, no. 53 (P-668)(2900) 18 February 1988 & JP-A-62 200 277**

## Description

This invention relates to a device for measuring the internal resistance of batteries, particularly of motor vehicles, of the type defined in the preamble of claim 1.

As is known, the internal resistance of a battery depends specifically on the temperature, on the state of wear of the battery, and also on the density and the level of the electrolyte, i.e. on the state of charge of the battery. It therefore represents a significant parameter which can be used for the diagnosis of the battery itself. This leads to the requirement of being able to measure the internal resistance of a battery in a simple and reliable way.

A known instrument for diagnosing the state of wear of batteries based on their internal resistance comprises a circuit which is connected to the battery and which generates an output voltage or current proportional to the internal resistance of the battery. The value of the output voltage or current is measured and displayed by means of a needle indicator, which can be calibrated so that it directly indicates the level of wear of the battery according to the position of the needle. Such a known instrument, which has a knob for manually setting the temperature of the battery to compensate for the effect of the latter on the internal resistance, is disadvantageous in that it does not enable the value of the resistance to be read directly, and most of all, moreover, in that it does not have a good resolution and is subject to the errors in reading which are typical of this type of device and which are associated with oscillations of the needle, which prevent an accurate value from being read off.

A device of the type defined in the preamble of claim 1 is disclosed in US-A-3,731,189, wherein no means is provided for eliminating surface charges, which may alter the measured results.

The object of this invention comprises the creation of a device for measuring the internal resistance of batteries which removes the problems of the known instrument, and which provides the accurate value of the resistance at its output, which can be displayed directly without requiring needle instruments to be read.

According to this invention a device is provided for measuring the internal resistance of batteries, particularly of motor vehicles, as defined by claim 1.

To provide a better understanding of this invention, a preferred form of construction will now be described, purely by way of a non-limiting example, by means of the accompanying drawings, where:

- Figure 1 is a simplified circuit diagram of the circuit used in the device of Figure 3;
- Figure 2 is a more detailed circuit diagram of this circuit;
- Figure 3 is a block circuit diagram of the device according to the invention, incorporating the circuit of Figure 2; and
- Figure 4 is a flow diagram relating to the calculation of the internal resistance.

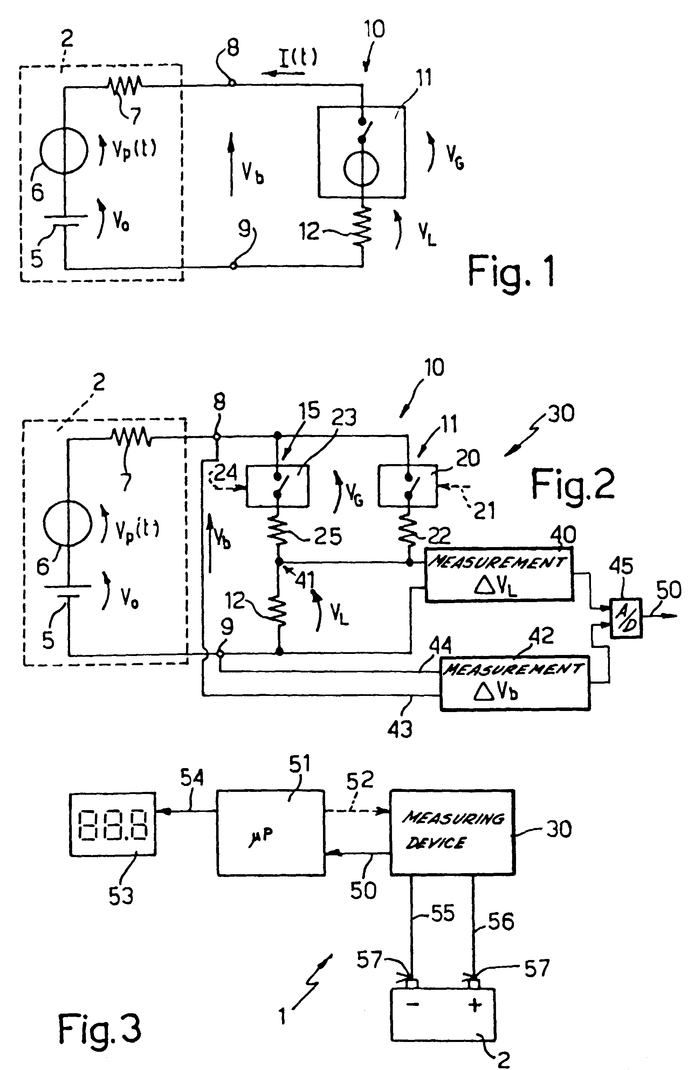

Figure 1 shows a simplified circuit diagram of a circuit 10 which forms part of this measuring device, to illustrate the principle on which the invention is based. The circuit 10 of Figure 1 is connected across the terminals 8 and 9 of a battery 2, the equivalent circuit of which is represented as comprising the connection in series of a first generator 5 of DC voltage $V_0$, of a second generator 6 of voltage $V_p(t)$ and of a resistor 7 of value RI; in this schematic diagram, the voltage $V_0$ represents the electrochemical potential (12 V ± 5%), the voltage $V_p(t)$ is the voltage drop due to surface charges; this voltage drop is positive after charging and negative after discharging the battery, varies slowly with time with respect to a rapidly alternating (100 Hz) voltage component, and must be considered as zero for dynamic purposes; finally the resistance RI represents the internal resistance of the battery, which is not affected by transient polarisation phenomena but is inversely proportional to the area of the elements and to the capacity (dimensions of the plates) and increases when the battery is discharged (by electrolysis or by sulphate formation).

The circuit 10 comprises the connection in series of an alternating 100 Hz generator of value $V_G$ and a known, stable, resistive load 12 of value $R_L$, which is switched by the generator 11.

The following relationship is valid for the circuit of Figure 1, where I(t) denotes the current flowing in the battery:

$$V_G(t) = (RI + R_L) * I(t) = V_p(t) + V_0 \qquad (1)$$

Differentiating with respect to time gives:

$$dV_G(t)/dt = (RI + R_L) * dI(t)/dt + dV_p(t)/dt +$$

$$dV_0/dt \qquad (2)$$

which with

$$dV_p(t)/dt = dV_0/dt = 0$$

under dynamic conditions gives:

$$dV_G(t)/dt = RI * dI(t)/dt + R_L * dI(t)/dt \qquad (3)$$

The substitution:

$$R_L * dI(t) = -dV_L(t) \qquad (4)$$

gives:

$$dI(t) = -dV_L(t)/dt/R_L \qquad (5)$$

and substituting (4) in (3) and solving for RI gives:

$$RI = [dV_G(t) + dV_L(t)]/dI(t). \qquad (6)$$

Substituting (5) in (6) gives:

$$RI = - \frac{dV_G(t) + dV_L(t)}{dV_L(t)} * R_L \qquad (7)$$

Moreover, since $V_G = V_b = V_L$, (7) may be rewritten as

$$RI = - \frac{dV_b - dV_L + dV_L}{dV_L} * R_L \qquad (8)$$

and therefore:

$$RI = - \frac{dV_b}{dV_L} * R_L \qquad (9)$$

It follows that it is possible to determine the internal resistance of the battery by obtaining the variation of $V_b$ and of $V_L$, and with an accurate knowledge of the value of $R_L$.

A more detailed circuit diagram of the circuit 10, and of the components intended to obtain the variation of $V_b$ and of $V_L$ (measuring device 30), is shown in Figure 2 and will be described below.

In Figure 2, the elements which are common to the simplified diagram of Figure 6 have been given the same reference numbers. In particular, the battery 2 is again represented schematically by the generators 5 and 6 and by the resistor 7. The load is again defined by the resistor 12; in series with the latter a connection of two branches in parallel is provided: one comprises the alternating generator 11, and the other defines a branch 15 for eliminating surface charges. These branches are thus interposed between one terminal of the load resistor 12 and the battery terminal 9.

In detail, the branch 11 comprises a first controlled switch 20 provided with a control terminal 21, and a suitable resistor 22 connected mutually in series. The branch 15, on the other hand, comprises a second controlled switch 23, provided with a control terminal 24 and a resistor 25 connected mutually in series. The switches 20 and 23 preferably comprise Smart power MOSFETs, and are controlled in such a way that the switch 23 always keeps the load 25 connected during the measurement, so that there is always a current which eliminates surface charges (and therefore the effect of $V_p(t)$ can be neglected), whilst the switch 20 switches the suitable load 22 at the desired frequency, which is 100 Hz in the case considered.

The device 30 also comprises a circuit 40 for measuring the variation of the voltage drop across the load 12, one side of which is connected to the battery terminal 9 and the other side of which is connected to the intermediate terminal 41 between the load 12 and the branches 11, 15, and a circuit 42 for measuring the variation in the battery voltage, connected to two signal lines 43 and 44, which end at the battery terminals 8 and 9. The circuits 40 and 42 may be formed, for example, by the cascade connection of an operational amplifier, which determines the differential voltage at its ends, comprising a rectangular wave with a frequency equal to the switching frequency of switch 20 (100 Hz), and a take-off stage for the peak-to-peak range. The outputs of the measuring circuits 40 and 42 are connected to the respective inputs of an A-D converter 45, which also operates as a multiplexer. The output of the converter 45 is connected to a line 50 (Figure 3), to supply the processing unit 51 alternately with the values $V_L$ and $V_b$; this therefore enables the unit 51 to calculate the value of the internal resistance Rl based on (9) which is sought.

As can be seen from Figure 3, the unit 51 is also connected via a unidirectional output line 52 to the measuring device 30 for sending the control pulses from the switches 20 and 23, as well as via a unidirectional output line 54 to a display unit 53 for displaying the value of the calculated internal resistance. In Figure 3, the measuring device 30 is shown provided with a pair of lines 55 and 56 which each end in a respective clamp 57 for connecting to the output terminals of the battery 2.

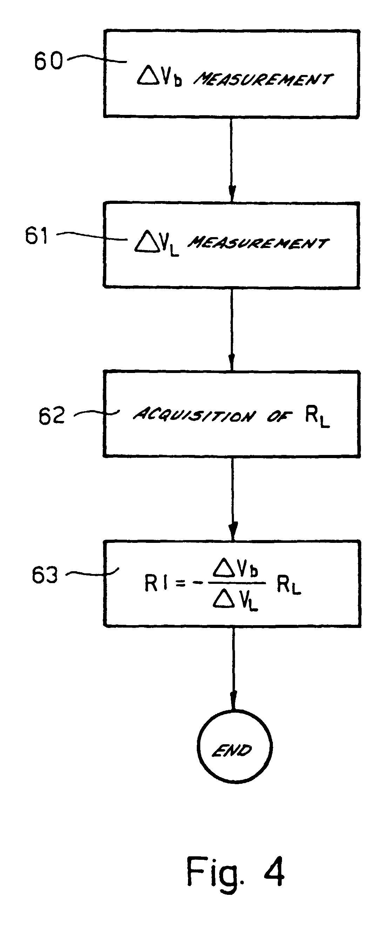

The operation of the device illustrated will now be described with reference to Figure 4, which relates to the flow diagram of the phases effected by the unit 51.

Initially (Block 60) the unit 51 obtains via the line 50 the value of the variation of the voltage of the battery $V_b$, measured by the unit 42 in the manner described above, then (Block 61) the same unit 51 obtains the value of the variation of the voltage across the load $V_L$, measured by the unit 40. Then the unit 51 obtains the value of the resistance $R_L$ (governed by a memory allocation, for example - Block 62), and finally calculates the value of the internal resistance Rl based on (9) in relation to the variation of the voltage drop of the battery and the variation of the voltage drop across the load, parameterised with respect to the resistance of the load (Block 63).

The advantages which can be obtained from the measuring device described are the following. First of all, the device 1 permits an accurate determination of the value of the internal resistance, and is then able to provide the numeric value via the display unit, without requiring a needle instrument to be read. Moreover, the device described does not involve a high power dissipation. In fact, with a circuit where the resistance of the load 12 is 10 $\Omega$, and resistors 25 and 22 are 8.2 and 50 $\Omega$ respectively, it is possible to obtain a current I(t) between 200 and 700 mA.

Moreover, the use of the device does not require any particular skill or lengthy operations on the part of the operator, since it only requires the connection of the clamps 57 to the terminals of the battery; as for the remainder, the determination of the necessary quantities is effected completely automatically. Furthermore, with the device described it is possible to eliminate the effect of surface charges which would falsify the result of the measurement, thus obtaining the effective value of the resistance of the load.

The circuit for measuring the internal resistance is extremely simple and therefore has a high reliability and reduced dimensions and cost.

Finally, it is clear that modifications and variations can be made to the device described and illustrated without this leading to a departure from the protected scope of this invention as defined by the claims. In particular, instead of referring all the operations relating to the control of the switching of the switches 20 and 23 to the unit 51, it is possible to provide a suitable logic circuit. Moreover, instead of providing the units 40 and 42, the digital values of the voltages $V_b$ and $V_L$ can simply be determined by the measuring device 30, and the determination of their variation due to the 100 Hz switching can be effected by means of the unit 51.

**Claims**

1. A device for measuring the internal resistance of batteries, particularly of motor vehicles, to be connected to the terminals (8, 9) of a battery (2), the device comprising:

   - a resistive load (12) connected across the terminals (8, 9) of the battery (2) via switching means (11) for switching said load at a predetermined frequency, said load having a predetermined resistive value ($R_L$), and generating a load voltage drop ($V_L$) variable with said predetermined frequency;
   - means (40) of determining the variation of said load voltage drop;
   - means (42) of determining the variation of the battery voltage drop ($V_b$) across said terminals; and
   - means (51) of calculating the internal resistance as the ratio between said variation of the battery voltage drop and said variation of the load voltage drop, said ratio being parametrized with respect to said resistive value of said load;

characterized in that the device comprises a circuit (15) for eliminating surface charges connected, in use, across the terminals (8, 9) of the battery (2).

2. A device according to Claim 1, characterised in that said calculating means comprise a processing unit (51) connected to display means (53) for the digital representation of said internal resistance.

3. A device according to Claims 1 or 2, characterised in that said switching means comprise a first branch (11) formed by the connection in series of a first controlled switch (20) and a first resistor (22), said first controlled switch having a control terminal (21) for receiving a digital open/close control signal having the predetermined frequency.

4. A device according to Claim 3, characterised in that said circuit for eliminating surface charges comprises a second branch (15) connected in parallel with said first branch (11) and formed by the connection in series of a second controlled switch (23) and a second resistor (25), said second controlled switch having a control terminal (24) for receiving a control signal keeping the second controlled switch closed during the determination of the variations of the voltage drops across the load and of the battery.

5. A device according to Claim 4, characterised in that said first and second controlled switches (20, 23) are formed as solid state switches.

6. A device according to one of Claims 2 to 5, characterised in that said processing unit (51) comprises microprocessor means and that said means for determining the variations of the load and battery voltage drops each have a respective output connected to an analog-digital converter element (45) and to a multiplexer having an output connected to said microprocessor unit (51).

**Patentansprüche**

1. Eine Vorrichtung zum Messen des Innenwiderstandes von Batterien, insbesondere von Motorfahrzeugen, mit den Anschlüssen (8, 9) einer Batterie (2) zu verbinden, umfassend:

   einer Widerstandslast (12), die über die Anschlüsse (8, 9) der Batterie (2) über eine Schaltvorrichtung (11) zum Schalten der Last mit einer vorbestimmten Frequenz verbunden ist, wobei die Last einen vorbestimmten Widerstandswert ($R_L$) aufweist und einen Lastspannungsabfall ($V_L$) erzeugt, der mit der vorbestimmten Frequenz variabel ist;

   eine Vorrichtung (40) zum Bestimmen der Veränderung des Lastspannungsabfalls;

   eine Vorrichtung (42) zum Bestimmen der Veränderung des Batteriespannungsabfalls ($V_b$) über den Anschlüssen; und

   eine Vorrichtung (51) zum Berechnen des Innenwiderstandes als des Verhältnisses zwischen der Veränderung des Batteriespannungsabfalls und der Veränderung des Lastspannungsabfalls, wobei das Verhältnis im Hinblick auf den Widerstandswert der Last parametrisiert ist,

   **dadurch gekennzeichnet, daß** die Vorrichtung eine Schaltung (15) einschließt, um Oberflächenladungen zu eliminieren, die beim Betrieb über den Anschlüssen (8, 9) der Batterie (2) verbunden sind.

2. Eine Vorrichtung nach Anspruch 1, **dadurch gekennzeichnet, daß** die Berechnungsvorrichtung eine Verarbeitungseinheit (51) umfaßt, die mit einer Anzeigevorrichtung (53) für die digitale Darstellung des Innenwiderstandes verbunden ist.

3. Eine Vorrichtung nach Anspruch 1 oder 2, **dadurch gekennzeichnet, daß** die Schaltvorrichtung einen ersten Arm (11) umfaßt, der durch die Serienschaltung eines ersten gesteuerten Schalters (20) und eines ersten Widerstandes (22) gebildet ist, wobei der erste gesteuerte Schalter einen Steueranschluß (21) aufweist, um ein digitales Öffnen/ Schließ-Steuersignal mit der vorbestimmten Frequenz zu empfangen.

4. Eine Vorrichtung nach Anspruch 3, **dadurch gekennzeichnet, daß** die Schaltung zum Entfernen von Oberflächenladungen einen zweiten Arm (15) umfaßt, der parallel mit dem ersten Arm (11) verbunden ist und durch die Serienschaltung eines zweiten gesteuerten Schalters (23) und eines zweiten Widerstandes (25) gebildet ist, wobei der zweite gesteuerte Schalter einen Steueranschluß (24) aufweist, um ein Steuersignal zu empfangen, das den zweiten gesteuerten Schalter während der Bestimmung der Veränderungen des Spannungsabfalls über der Last und der Batterie geschlossen hält.

**5.** Eine Vorrichtung nach Anspruch 4, **dadurch gekennzeichnet, daß** der erste und zweite gesteuerte Schalter (20, 23) als Volltransistorschalter ausgebildet sind.

**6.** Eine Vorrichtung nach einem der Ansprüche 2 bis 5, **dadurch gekennzeichnet, daß** die Verarbeitungseinheit (51) eine Mikroprozessorvorrichtung einschließt und daß die Vorrichtung zum Bestimmen der Veränderungen des Last- und Batteriespannungsabfalls jede einen jeweilgen Ausgang aufweist, der mit einem Analog/Digital-Wandlerelement (45) und mit einem Multiplexer, der einen mit der Mikroprozessoreinheit (51) verbundenen Ausgang aufweist, verbunden ist.

**Revendications**

**1.** Dispositif destiné à mesurer la résistance interne d'une batterie, en particulier, de véhicules à moteur, qui doit être connecté sur les bornes (8, 9) d'une batterie (2), le dispositif comprenant:

    une charge résistive (12) connectée entre les bornes (8, 9) d'une batterie (2) par l'intermédiaire d'un moyen de commutation (11) destiné à commuter ladite charge à une fréquence prédéterminée, ladite charge présentant une valeur ohmique prédéterminée ($R_L$) et produisant une chute de tension de charge ($V_L$) variable en fonction de ladite fréquence prédéterminée;
    un moyen (40) destiné à déterminer la variation de ladite chute de tension de charge;
    un moyen (42) destiné à déterminer la variation de la chute de tension de batterie ($V_b$) entre lesdites bornes; et
    un moyen (51) destiné à calculer la résistance interne comme le rapport entre ladite variation de la chute de tension de batterie et ladite variation de la chute de tension de charge, ledit rapport pouvant être paramétré en fonction de ladite valeur ohmique de ladite charge;

    caractérisé en ce que le dispositif comprend un circuit (15) destiné à éliminer les charges de surface connecté, en utilisation, entre les bornes (8, 9) de la batterie (2).

**2.** Dispositif selon la revendication 1, caractérisé en ce que ledit moyen de calcul comprend une unité de traitement (51) connectée à un moyen d'affichage (53) permettant la représentation numérique de ladite résistance interne.

**3.** Dispositif selon la revendication 1 ou 2, caractérisé en ce que ledit moyen de commutation comprend une première branche (11) formée par la connexion en série d'un premier commutateur commandé (20) et d'une première résistance (22), ledit premier commutateur commandé comportant une borne de commande (21) destinée à recevoir un signal de commande numérique d'ouverture/fermeture présentant une fréquence prédéterminée.

**4.** Dispositif selon la revendication 3, caractérisé en ce que ledit circuit destiné à éliminer les charges de surface comprend une seconde branche (15) connectée en parallèle avec ladite première branche (11) et qui est formée par la connexion en série d'un second commutateur commandé (23) et d'une seconde résistance (25), ledit second commutateur commandé comportant une borne de commande (24) destinée à recevoir un signal de commande maintenant fermé le second commutateur commandé pendant la détennination des variations des chutes de tension à travers la charge et de la batterie.

**5.** Dispositif selon la revendication 4, caractérisé en ce que lesdits premier et second commutateurs commandés (20, 23) sont constitués par des commutateurs à semi-conducteurs.

**6.** Dispositif selon l'une quelconque des revendications 2 à 5, caractérisé en ce que ladite unité de traitement (51) comprend un moyen à microprocesseur et en ce que lesdits moyens destinés à déterminer les variations des chutes de tension de charge et de batterie comportent chacun une sortie respective connectée à un élément convertisseur analogique-numérique (45) et à un multiplexeur comportant une sortie connectée à ladite unité à microprocesseur (51).

Fig. 1

Fig. 2

Fig. 3

60 → $\triangle V_b$ *MEASUREMENT*

61 → $\triangle V_L$ *MEASUREMENT*

62 → *ACQUISITION OF* $R_L$

63 → $RI = -\dfrac{\triangle V_b}{\triangle V_L} R_L$

*END*

# Fig. 4